(19) Europäisches Patentamt / European Patent Office / Office européen des brevets

(11) **EP 4 389 321 B1**

(12) **EUROPEAN PATENT SPECIFICATION**

(45) Date of publication and mention
of the grant of the patent:
**24.09.2025 Bulletin 2025/39**

(21) Application number: **22215315.7**

(22) Date of filing: **21.12.2022**

(51) International Patent Classification (IPC):
*B22F 3/24* *(2006.01)*   *B22F 7/00* *(2006.01)*
*C22C 1/05* *(2023.01)*   *C22C 1/10* *(2023.01)*
*C22C 29/06* *(2006.01)*  *C22C 29/08* *(2006.01)*
*C23C 14/00* *(2006.01)*  *C23C 14/06* *(2006.01)*
*C23C 14/08* *(2006.01)*  *C23C 14/58* *(2006.01)*
*C23C 28/04* *(2006.01)*  *C23C 30/00* *(2006.01)*
*B22F 5/00* *(2006.01)*

(52) Cooperative Patent Classification (CPC):
(C-Sets available)
**C22C 29/08; B22F 3/24; B22F 7/008; C22C 1/05;
C22C 1/1084; C22C 29/067; C23C 14/0015;
C23C 14/0641; C23C 14/081; C23C 14/5886;
C23C 28/044; C23C 30/005;** B22F 2005/001;
B22F 2999/00                              (Cont.)

(54) **A COATED CUTTING TOOL**

BESCHICHTETES SCHNEIDWERKZEUG

OUTIL DE COUPE REVÊTU

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(43) Date of publication of application:
**26.06.2024 Bulletin 2024/26**

(73) Proprietor: **WALTER AG
72072 Tübingen (DE)**

(72) Inventors:
• **Garcia, José Luis
  72072 Tübingen (DE)**
• **Schier, Veit
  72072 Tübingen (DE)**
• **Gold, Christian
  72072 Tübingen (DE)**

(74) Representative: **Sandvik
Sandvik Intellectual Property AB
811 81 Sandviken (SE)**

(56) References cited:
**EP-A1- 3 393 703     EP-A1- 3 839 097**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)

C-Sets
B22F 2999/00, B22F 3/10, B22F 2201/11,
B22F 2201/04;
B22F 2999/00, B22F 9/04, B22F 3/02, B22F 3/10,
B22F 2003/241

**Description**

TECHNICAL FIELD

The present invention relates to a coated cutting tool. The cutting tool can be PVD coated and the substrate is a cemented carbide wherein the cemented carbide comprises WC, Co, eta phase grains and Cr.

BACKGROUND

Cutting tools for metal cutting are often made of cemented carbide substrate provided with a wear resistant coating. A cutting tool for a milling operation should have a high wear resistance, a high edge line toughness and also a high hardness at high temperatures. In milling applications one of the wear mechanisms of the cutting tool is the formation of comb cracks. A milling cutting tool is subjected to cycles of heating and cooling and this expands and contracts the surface of the tool which can lead to the formation of comb cracks along the cutting edge.

The comb crack resistance can be handled by adjustments in the compressive stresses in the PVD layer. The wear evaluation during milling of grey cast iron has been studied and it was found that when a comb crack has been generated in a cutting application, the crack proceeds with extensive attack to the binder. When the binder is attacked wear of the cutting tool progresses quickly for example in that the coating will detach and the cutting edge of the cutting tool has an increased risk of edge breakage.

WO2017108610 discloses a cemented carbide comprising finely dispersed eta phase that has shown an increased resistance against comb cracks.

EP3393703 B1 relates to a cutting tool comprising a substrate of cemented carbide which comprises a controlled amount of fine dispersed eta phase.

EP3839097 A1 relates to a coated cutting tool comprising a substrate body of cemented carbide and a wear resistant coating applied to the substrate.

It is an object of the present invention to provide a milling cutting insert with enhanced comb crack resistance and adequate toughness and wear resistance, especially in ISO-K milling applications such as cast iron milling.

DESCRIPTION OF THE INVENTION

At least one of the above-mentioned objects is achieved by a cutting tool according to claim 1. Preferred embodiments are disclosed in the dependent claims.

It was realized that with the composition of the cemented carbide according to this invention the chemical resistance of the metallic binder can be improved while keeping the toughness and the hardness of the cemented carbide.

The cutting tool as disclosed herein can for example be an insert or an endmill designed for milling applications.

The cemented carbide of the present invention comprises WC grains and eta phase grains embedded in a metallic binder. The metallic binder comprises Co and Cr and also W that is dissolved into the metallic binder from the WC grains during the sintering of the cemented carbide.

By a coating on the cutting tool is herein meant a coating that is deposited on the cemented carbide substrate to increase the wear resistance of the cutting tool. This coating can for example be a coating deposited with Physical Vapor Deposition (PVD).

The Co content in the cemented carbide of the present invention is preferably 6-12 wt% Co. If the Co content is lower than 6 wt% the cutting tool will lose in toughness properties. If on the other hand the Co content is higher than 12 wt% the cutting tool will lose in comb crack resistance. A Co content higher than 12 wt% will also make the cutting tool sensitive to chemical attacks by a cooling media used in milling application and by the work piece material during the cutting.

The eta phase content in the cemented carbide of the present invention is 4-5 vol%. If the eta phase content is higher than 5 vol% a large part of the Co content in the metallic binder is consumed into the eta phase grains and this would make the cemented carbide too brittle. If the eta phase content is lower than 4 vol% there is an increased risk that the eta phase grains forms clusters and these are brittle instead of the well distributed eta grains.

The Cr content in the cemented carbide of the present invention is such that Cr(wt%)/ Co(wt%) is 1.0-2.5 %. It was surprisingly found that this content of Cr in the cemented carbide improved the cutting tool properties. With Cr added in the cemented carbide the eta phase grains will include Cr and the eta phase will be $(W,Co,Cr)_xC$. Cr will also remain in solid solution in the metallic binder phase comprising Co. Cr will also act as a grain growth inhibitor during the sintering and restrict continued growth and coarsening of the WC grains. If the Cr content is too low Cr will still effect the WC grain size growth, but the solid solution will be limited. If the Cr is too high the cemented carbide will be too hard and too brittle for ISO-K milling applications. The cemented carbide with the Cr content within the weight ratio range Cr/Co 1.0-2.5 % has due to the solid solution effect a high strengthening. The work hardening properties of Co is improved, the hot hardness properties are improved, and also chemical resistance, i.e. corrosion resistance is improved.

The cemented carbide according to the present invention has a low carbon content so that eta phase grains are formed. This will result in a cemented carbide having both a W content in the binder and eta phase grains. By eta phase is herein meant carbides selected from $Me_{12}C$ and $Me_6C$ where Me is selected from W, Co and Cr so the carbides could be $(W,Co,Cr)_6C$ and/or $(W,Co,Cr)_{12}C$.

In the present invention the cemented carbide comprises fine dispersed eta phase grains. Eta phase grains can exist as very large, brittle and unwanted form with grain sizes typically above 50 $\mu$m or even larger than 100 $\mu$m and these are not part of the present invention. The eta phase grains of the present invention are 1-5 $\mu$m in average grain size and these grains are evenly distributed within the metallic binder of the cemented carbide. The fine dispersed eta phase grains of the present invention are formed during the sintering process and carbon deficiency and equilibrium temperature needs to be controlled in the process to reach the claimed eta phase appearance and content. The difference in substoichiometric carbon content between achieving the unwanted large agglomerates of eta phase, and achieving the finely distributed eta phase, that it is aimed for, can be very small. Being close to that limit requires monitoring the microstructure to make sure that the unwanted large agglomerates are avoided. Carefully adjusting carbon contents and then monitor its result in terms of the obtained microstructure is a known working procedure to a person skilled in the art.

In the present invention the cemented carbide comprises 75-91 vol% WC, preferably 80-87 vol% WC.

In one embodiment of the present invention the content, i.e. area fraction, of eta phase grains in a portion of the substrate adjacent to the surface of the substrate corresponds to the content in the innermost portion of the substrate. In one embodiment of the present invention, the eta phase distribution is constant throughout the whole cemented carbide substrate, i.e. the cemented carbide does not comprise any gradients of eta phase or zones without eta phase, like e.g. in US4,843,039. The distribution of the eta phase is preferably as even as possible.

In one embodiment of the present invention the WC grain size in the cemented carbide is 0.6-0.8 $\mu$m.

In one embodiment of the present invention the cemented carbide consists of WC grains and eta phase grains in a metallic binder of Co and Cr and wherein some W is dissolved in the metallic binder. W will inevitably be dissolved in the metallic binder during sintering and the exact amount depends on several things, such as the overall composition of the cemented carbide, the exact carbon content etc.

In one embodiment of the present invention the coating is a PVD coating.

In one embodiment of the present invention the coating thickness is 2.5 - 4.5 $\mu$m.

In one embodiment of the present invention the coating is a multilayer with at least one layer of TiAlN and at least one layer of $Al_2O_3$.

In one embodiment of the present invention the $Al_2O_3$ is nanocrystalline $\gamma$- $Al_2O_3$ and wherein the Ti:Al ratio in the TiAlN is 33:67.

In one embodiment of the present invention the coating comprise an outermost layer of metallic Al as a wear indication layer, preferably with a layer thickness of 30-100 nm.

In one embodiment of the present invention the coating consists of the sublayers TiAlN/ $\gamma$-$Al_2O_3$ / TiAlN/ $\gamma$- $Al_2O_3$ / TiAlN/ $\gamma$- $Al_2O_3$ / TiAlN/ Al.

In one embodiment of the present invention the cutting tool is a milling insert.

In one embodiment of the present invention the cutting tool has been subjected to shot peening.

METHODS

The cemented carbide of the present invention is made in accordance with normal cemented carbide manufacturing methods. The steps of milling, drying, pressing and sintering is used.

The carbon content needs to be adjusted during the cemented carbide manufacturing to achieve the correct eta phase content.

The formation of evenly or finely distributed eta phase grains in accordance with the present invention is achieved by controlling the carbon content carefully during the cemented carbide manufacturing. The cemented carbide in the present invention is made with a substoichiometric carbon content within a certain range. Substoichiometric carbon is a measure of the carbon content in relation to the stoichiometric carbon content. The substoichionetric content is a good measurement to use since it is not dependent on other parameters like binder phase content, other carbides etc.

Suitably the carbon content is between -0.30 and -0.16 wt% substoichiometric carbon, preferably between -0.28 and -0.17 wt% substoichiometric carbon.

The stoichiometric carbon content is calculated by assuming that the carbides in the cemented carbide are completely stoichiometric, for example the atomic ratio W:C is assumed to be 1:1. When other carbide forming elements are present in the cemented carbide, such as Cr, the corresponding carbide $Cr_3C_2$, is also assumed to be stoichiometric.

The stoichiometric carbon content in a sintered cemented carbide, e.g. consisting of Co and WC, can either be calculated based on the amount of added WC raw material in the powder, assuming that the atomic ratio W:C is 1:1, or from measurements of for example W in the sintered material and then from the measured content calculate the stoichiometric carbon content assuming that the atomic ratio W:C is 1:1.

This means that the term substoichiometric carbon, as used herein, is the total carbon content in the cemented carbide determined by chemical analysis minus the calculated stoichiometric carbon content based on WC and possible other carbides present in the cemented carbide. In the sintered cemented carbide:

[Carbon content] = [stoichiometric carbon content] + [subsoichiometric carbon content]

As an example, if the stoichiometric carbon content for a particular cemented carbide is 5.60 wt%, and this cemented carbide would be made with a carbon content of 5.30 wt%, the substoichiometric carbon content would be -0.30 wt%.

It is important that the carbon content is measured on the sintered cemented carbide, since some of the carbon will be lost during sintering due to the formation of e.g. $CO_2$. The exact amount of carbon lost depends on the specific sintering furnace and sintering process. The powder will thus have a small excess of carbon compared to what is aimed for in the sintered cemented carbide.

The Co and Cr content in the cemented carbide can be measured by chemical analysis with XRF (X-ray fluorescence) using a Panalytical Axios Max Advanced instrument. The value achieved is the total Cr and/or Co content both in binder, in eta phase grains and in grain boundaries.

Carbon content in the sintered cemented carbide or the powder can be measured by the LECO WC-600 instrument.

The amount of eta phase in the cemented carbide was determined by image analysis of LOM (light optical microscope) using the software Image J using the setup "Automatic". The magnifications of the images were 1000X and 2000X, two measurements were done at each magnification and the values in Table 2 are an average value of these. The value in the table is thus an average from a total of four image analyses performed on the two images, 2 measurements on each image. The area fraction in the image is considered to correspond to the volume fraction in the cemented carbide. The volume fraction of WC can be determined in the corresponding way as the eta phase volume fraction.

The average grain size of the eta phase grains and the WC grains is measured by mean linear intercept on a LOM image at 1000x or 2000x magnification.

The layer thicknesses in the coating were measured in a polished cross section in an SEM image.

The hardness and the toughness of the cemented carbide was measured using Vickers indentation.

## BRIEF DESCRIPTION OF DRAWINGS

Embodiments of the invention will be described with reference to the accompanying drawings, wherein:

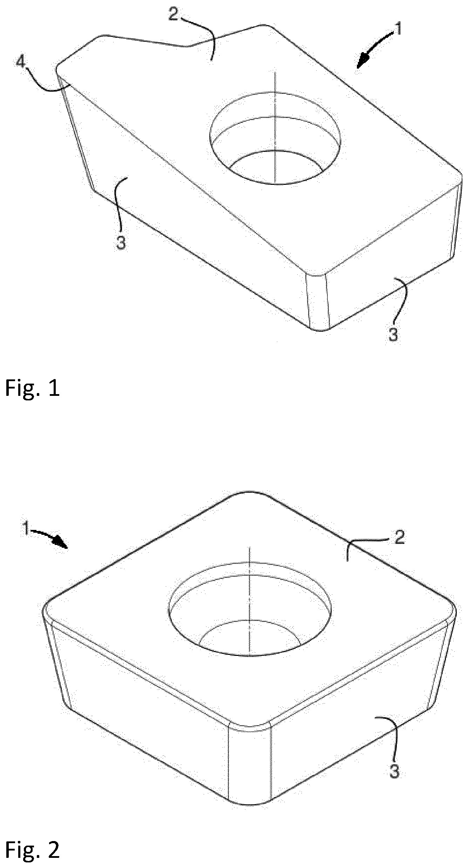

FIG. 1 shows a schematic view of one embodiment of a cutting tool (1) being a milling insert with a rake face (2), a flank face (3) and a cutting edge (4) therebetween,
FIG. 2 shows a schematic view of one embodiment of a cutting tool (1) being a turning insert with a rake face (2), a flank face (3) and a cutting edge therebetween,

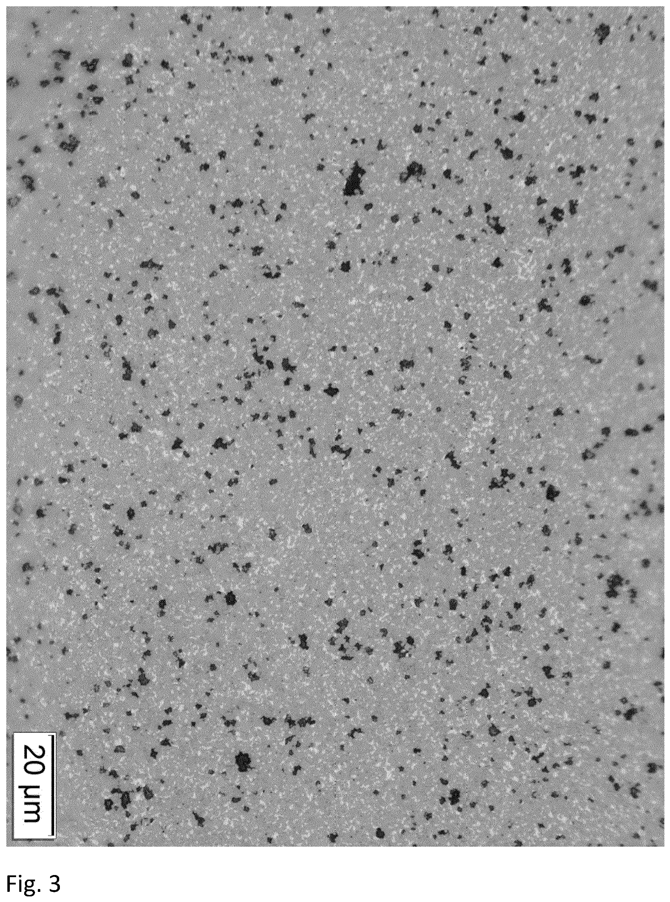

FIG. 3 shows a LOM (Light Optical Microscope) cross-section of the substrate of Invention 1, cemented carbide comprising eta phase grains (black), WC grains (grey) and metallic bidnder (white) and comprising Cr,

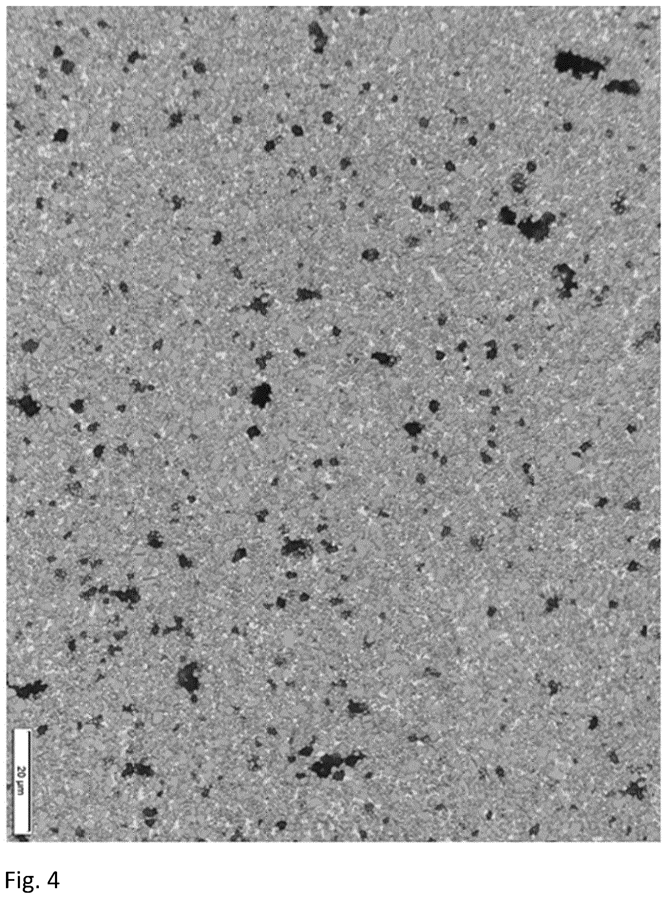

FIG. 4 shows a LOM cross-section of the substrate of Comparative 1, cemented carbide with eta phase grains (black), WC grains (grey) and metallic binder (white) but without Cr, and

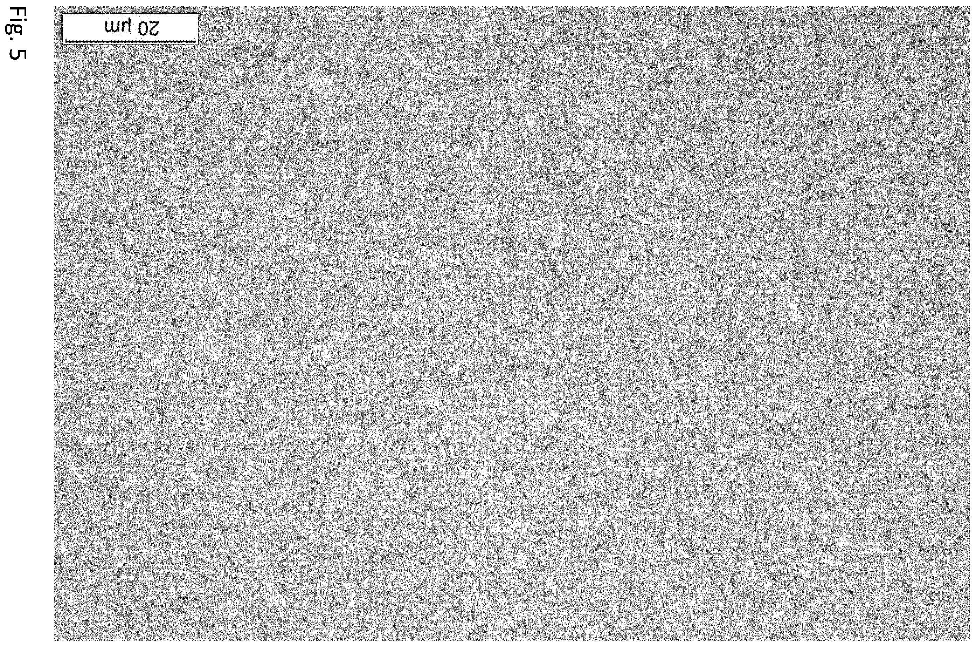

FIG. 5 shows a LOM cross-section of the substrate of Reference 1, WC/Co cemented carbide with no eta phase grains and no Cr.

## EXAMPLES

Exemplifying embodiments of the present invention will now be disclosed in more detail and compared to reference embodiments. Coated cutting tools (inserts) were manufactured and analysed and evaluated in cutting tests.

Substrates

Cemented carbide substrates were manufactured. Three different compositions were made: Invention 1 is a cemented carbide comprising eta phase grains and Cr, Comparative 1 is a cemented carbide comprising eta phase grains but no Cr, Reference 1 is a cemented carbide composed of WC and metallic Co.

The cemented carbides were made from raw material powders in accordance with Table 1.

Table 1. Powder composition

| Sample | Cr [wt%] | Co [wt%] | WC [wt%] | WC grain size [μm] | W addition [wt%] |
|---|---|---|---|---|---|
| Invention 1 | 0.15 | 7.4 | Balance | 1.37 | 2.1 |
| Comparative 1 | 0 | 7.4 | Balance | 1.37 | 1.9 |
| Reference 1 | 0 | 6.0 | Balance | 1.37 | - |

The powders were milled in a ball mill together with a milling liquid (water/ethanol with a ratio of 9/91) and an organic binder, 2 wt %PEG. The amount of PEG is not included in the dry powder weight presented in Table 1. After the milling the slurry was pan dried. The dried agglomerates were then pressed into a green body. The green body was sintered in 40 mbar in Ar and CO at 1410°C.

The amount of eta phase was determined by image analysis of LOM (light optical microscope) using the software Image J using the setup "Automatic". The magnifications of the images were 1000X and 2000X, two measurements were done at each magnification and the values in Table 3 are an average value of these. The values in the table is thus an average from a total of four image analyses performed on the two images, 2 measurements on each image.

The stoichiometric carbon content in the sintered cemented carbide is calculated by first measuring the total carbon content in the sintered cemented carbide by using a LECO WC-600 instrument, for this analysis, the sample was crushed prior to the analysis. The accuracy of the values is ±0.01 wt%. The W, Co and Cr content is measured with XRF (X-ray fluorescence) using a Panalytical Axios Max Advanced instrument. By subtracting the cobalt, the chromium and carbon amounts from the total weight of the sample, the W content is achieved which is used to calculate the stoichiometric carbon content, assuming the WC has a 1:1 ratio.

By subtracting the stoichiometric carbon content from the total carbon as measured by the LECO WC-600 instrument, the substoichiometric carbon value is achieved. As can be seen in Table 2, the substoichiometric carbon value in the sintered material differs from that in the powder. This is due to that some of the carbon reacts with oxygen and outgas as CO or $CO_2$ during sintering, and this reduces the total final C content of the cemented carbide.

The carbon in the powder was adjusted to achieve the desired microstructure in the sintered cemented carbides. The measured carbon content in the powder and in the sintered cemented carbide substrate, are given in Table 2.

Table 2. Carbon content in powders and in cemented carbides

| Sample | Substoichiometric carbon in powder [wt%] | Substoichiometric carbon in sintered cemented carbide [wt%] |
|---|---|---|
| Invention 1 | - 0.14 | - 0.26 |
| Comparative 1 | - 0.13 | - 0.25 |
| Reference 1 | 0.08 | - 0.03 |

The compositions of the sintered cemented carbide substrates are given in Table 3. Also the eta phase content and the average grain size of the eta phase grains were measured in accordance with the method disclosed above. The distribution of the eta phase grains in the cemented carbides of Invention 1 and Comparative 1 were both continuous through the whole body, no gradient in eta phase content was observed. No gamma phase grains, no very large eta phase grains and no graphite was found in the cemented carbide.

Table 3. Substrate composition

| Sample | WC average grain size in sintered [μm] | Cr [wt%] | Co [wt%] | Cr/Co [%] | Eta phase [vol%] | Eta phase average grain size [μm] |
|---|---|---|---|---|---|---|
| Invention 1 | 0.66 | 0.15 | 7.4 | 2 | 4.5 | 2.5 |
| Comparative 1 | 0.78 | 0 | 7.4 | 0 | 4.5 | 3.5 |
| Reference 1 | 0.8 | 0 | 6 | 0 | 0 | - |

Eta consumes about 1.4wt% Co to form in the Invention 1 and Comparative samples so the 6% Co in the Reference 1 therefore makes it comparable with the Invention 1 and the Comparative 1 samples that comprise eta phase grains.

The area fraction of the WC, the eta phase grains and the metallic binder of the cemented carbides were studied in LOM and in SEM. The volume fractions are presented in Table 4.

Table 4. Volume fractions in cemented carbide

| Sample | WC [vol%] | Metallic binder [vol%] | Eta phase [vol%] |
|---|---|---|---|
| Invention 1 | 85.5 | 10 | 4.5 |
| Comparative 1 | 85.6 | 9.9 | 4.5 |
| Reference 1 | 89.9 | 10.1 | 0 |

Hardness and toughness were measured in accordance with the method disclosed above and the achieved values are presented in Table 5.

Table 5. Hardness and toughness

| Sample | Hardness [HV3] | Toughness K1C [MN/m$^{3/2}$] |
|---|---|---|
| Invention 1 | 1620 | 9.5 |
| Comparative 1 | 1590 | 9.1 |
| Reference 1 | 1570 | 9.4 |

The inventive sample Invention 1 showed both a higher hardness and a higher toughness as compared to both the reference sample Reference 1 and the comparative sample Comparative 1.

Coating

The sintered cemented carbide substrates were all coated in a PVD process with a wear resistant PVD coating. The coating equipment used for depositing the PVD coating of the present invention was a Hauzer HTC1000 (IHI Hauzer Techno Coating B.V, The Netherlands) with a chamber size of about 1 m$^3$.

The layer thicknesses of the deposited layers were measured on the flank face of the insert.

The PVD coating included the following layers from the substrate:
A first inner layer of TiAlN with a thickness of 2 $\mu$m with a Al:Ti ration of 67:33. The crystal structure is mainly cubic, only minor amount of hexagonal AlN phase.

Thereafter a layer of nanocrystalline $\gamma$-Al$_2$O$_3$ with a thickness of 0.5 $\mu$m.

On top of the $\gamma$-Al$_2$O$_3$ layer is a 0.7 $\mu$m in thickness multilayer deposited wherein said multilayer consist of the layer sequence TiAlN/ $\gamma$-Al$_2$O$_3$/ TiAlN/ $\gamma$-Al$_2$O$_3$. The TiAlN has an atomic ratio Al:Ti of 67:33. All the four layers has about the same layer thicknesses i.e. about 0.175 $\mu$m each.

Thereafter a layer of TiAlN with a thickness of 0.6 $\mu$m with an atomic ratio Al:Ti of 67:33.

An outermost metallic color layer of Al with a layer thickness of about 50 nm is finally deposited. This is thick enough to give a "silver like" color. This top layer can for example be blasted away on rake face of the cutting tool.

The total thickness of the PVD coating was 3.8 $\mu$m as measured on the flank face of the cutting tool."

Post treatment

Some of the PVD coated substrates were subjected to a dry blasting process and these samples are named with an ending SP below. The dry blasting was made in a commercial equipment for dry blasting using commercial Zirconia beads. The beads were of the diameter 70-125 $\mu$m. The blasting pressure was 5.3 bar, the belt speed 150 mm/min. A dry blasting process influences the toughness properties of the cutting tool.

Performance testing

Test 1

Coated cutting tools of the geometry P2808.1 were tested in a roughing milling operation with workpiece material of GG25/GJL250, a cast iron (ISO K). The cutting speed $v_c$ was 200 m/min, the feed rate, $f_z$, was 0.25 mm/tooth, the number of teeth in the cutter, z, was 1, the depth axial of cut, $a_p$, was 3 mm and the radial depth of cut, $a_e$, 100 mm. Water miscible cutting fluid was used. The width of wear on the rake face of the cutting tool was detected via optical measurement on main cutting edge for defined intervals of milling distance. The average results of the maximum wear at a milling distance of 5600 mm of 2 parallel cutting tests per type of sample are presented in Table 6.

Table 6.

| Sample | Maximum width of wear at cutting edge [mm] |
|---|---|
| Reference 1 | 0.52 |
| Reference 1 SP | 0.52 |
| Comparative 1 | 0.24* |
| Comparative 1 SP | 0.21* |
| Invention 1 | 0.18 |
| Invention 1 SP | 0.16 |
| *same test conditions as in the Invention 1 and Reference 1 runs but with another batch of workpiece material which can have an influence on the results. | |

Test 2

Coated cutting tools of the insert geometry SNMX120512-D27 were tested in a roughing milling operation with workpiece material of GG25/GJL250, a cast iron (ISO K). The cutting speed $v_c$ was 220 m/min, the feed rate, $f_z$, was 0.36 mm/tooth, the number of teeth in the cutter, z, was 8, the depth axial of cut, $a_p$, was 3 mm and the radial depth of cut, $a_e$, up to 60 mm. Cutting fluid was not used. The tool life criterion was set to an increase in power consumption and a decrease in running smoothness. The machining was continued until the end of life time criterion was reached. The average results of 4 parallel cutting tests per type of sample are presented in Table 7.

Table 7

| Sample | Tool life [min] |
|---|---|
| Reference 1 | 75 |
| Invention 1 | 100 |

Test 3

Coated cutting tools of the geometry ADGT1606PERD56 were tested in a finishing milling operation with workpiece material of GGG50/GJS50014, a middle grade cast iron (ISO K). The cutting speed $v_c$ was 360 m/min, the feed rate, $f_z$, was 0.2 mm/tooth, the number of teeth in the cutter, z, was 6, the depth axial of cut, $a_p$, was 0.3 mm and the radial depth of cut, $a_e$, up to 55 mm. Water miscible cutting fluid was used. The machining was continued for 80 min. After the machining the maximum width of wear on the rake face of the cutting tool was detected via optical measurement on main cutting edge. The average results of 6 parallel cutting tests per type of sample are presented in Table 8.

Table 8

| Sample | Maximum wear [mm] |
|---|---|
| Reference 1 | 0.76 |
| Invention 1 | 0.45 |

Test 4

Coated cutting tools of the geometry SDMW09T320A57 were tested in a roughing milling operation with workpiece material of Sibodur 700, a highly ductile spheroidal cast iron (ISO K). The cutting speed $v_c$ was 87 m/min, the feed rate, $f_z$, was 0.15 mm/tooth, the number of teeth in the cutter, z, was 3, the depth axial of cut, $a_p$, was 69 mm and the radial depth of cut, $a_e$, 60 mm. Water miscible cutting fluid was used. The tool life criterion was set to absolute power consumption higher than 15 kW. The machining was continued until the end of life time criterion was reached. The average results of 4 parallel cutting tests per type of sample are presented in Table 9.

Table 9.

| Sample | Number of pieces |
| --- | --- |
| Reference 1 | 300 |
| Invention 1 | 480 |

It should be noted that the embodiments of the present disclosure is for the explanation of the present disclosure, and not for the limitation of the present invention. The scope of the present invention is defined in the appended claims.

**Claims**

1.  A coated cutting tool comprising a body of cemented carbide and a coating thereon, wherein the cemented carbide comprises 75-91 vol% WC grains and eta phase grains and metallic binder, wherein the metallic binder comprises Co and Cr, the Co content in the cemented carbide is 6-12 wt%, preferably 6-10 wt%, more preferably 7-8 wt%, the eta phase content is 4-5 vol% and the average grain size of the eta phase grains is 1-5 $\mu$m, preferably 2-4 $\mu$m, more preferably 2-3 $\mu$m, the vol% and average grain size of the eta grains are measured in accordance with the method as described in the description, and wherein the substoichiometric carbon content is between -0.30 and - 0.16 wt%, **characterized in that** the Cr/Co ratio in the cemented carbide is 1.0 - 2.5 %.

2.  The coated cutting tool according to claim 1, wherein the Cr/Co ratio in the cemented carbide is 1.5 - 2.5 %.

3.  The coated cutting tool in accordance with any of the preceding claims, wherein the content of eta phase in a portion of the substrate adjacent to the surface of the substrate corresponds to the content of eta phase in the innermost portion of the substrate.

4.  The coated cutting tool in accordance with any of the preceding claims, wherein the WC grain size in the cemented carbide is 0.6-0.8 $\mu$m as measured by mean linear intercept on a LOM image at 1000x or 2000x magnification.

5.  The coated cutting tool in accordance with any of the preceding claims, wherein cemented carbide consists of WC grains and eta phase grains in a metallic binder of Co and Cr and wherein some W is dissolved in the metallic binder.

6.  The coated cutting tool in accordance with any of the preceding claims, wherein the coating is a PVD coating.

7.  The coated cutting tool in accordance with any of the preceding claims, wherein the coating thickness is 2.5 - 4.5 $\mu$m as measured in a polished cross section in an SEM image.

8.  The coated cutting tool in accordance with any of the preceding claims, wherein the coating is a multilayer with at least one layer of TiAlN and at least one layer of $Al_2O_3$.

9.  The coated cutting tool in accordance with claim 8 wherein the $Al_2O_3$ is nanocrystalline $\gamma$-$Al_2O_3$.

10. The coated cutting tool in accordance with any of claims 8-9 wherein the Ti:Al ratio in the TiAlN is 33:67.

11. The coated cutting tool in accordance with any of the preceding claims, wherein the coating comprises an outermost layer of metallic Al as a wear indication layer, preferably with a layer thickness of 30-100 nm.

12. The coated cutting tool in accordance with any of the preceding claims, wherein the coating consists of the sublayers TiAlN/ $\gamma$-$Al_2O_3$/ TiAlN/ $\gamma$-$Al_2O_3$/ TiAlN/ $\gamma$-$Al_2O_3$/ TiAlN/ Al.

13. The coated cutting tool in accordance with any of the preceding claims, wherein the cutting tool is a milling insert.

14. The coated cutting tool in accordance with any of the preceding claims, wherein the cutting tool has been subjected to shot peening.

**Patentansprüche**

1. Beschichtetes Schneidwerkzeug mit einem Körper aus Hartmetall und einer Beschichtung darauf, wobei das Hartmetall 75-91 Vol.-% WC-Körner enthält und Eta-Phase-Körner und einen metallischen Binder, wobei der metallische Binder Co und Cr enthält, wobei der Co-Gehalt im Hartmetall 6-12 Gew.-%, vorzugsweise 6-10 Gew.-%, noch bevorzugter 7-8 Gew.-% beträgt, wobei der Eta-Phase-Gehalt 4 bis 5 Vol.-% beträgt und die durchschnittliche Korngröße der Eta-Phase-Körner 1 bis 5 $\mu$m, vorzugsweise 2 bis 4 $\mu$m, noch bevorzugter 2 bis 3 $\mu$m beträgt, wobei der Volumenanteil und die durchschnittliche Korngröße der Eta-Körner gemäß dem in der Beschreibung beschriebenen Verfahren gemessen werden und wobei der substöchiometrische Kohlenstoffgehalt zwischen -0,30 und -0,16 Gew.-% liegt, **dadurch gekennzeichnet, dass** das Cr/Co-Verhältnis im Sinterkarbid 1,0 bis 2,5 % beträgt.

2. Beschichtetes Schneidwerkzeug nach Anspruch 1, wobei das Cr/Co-Verhältnis im Hartmetall 1,5 bis 2,5 % beträgt.

3. Beschichtetes Schneidwerkzeug nach einem der vorstehenden Ansprüche, wobei der Gehalt an Eta-Phase in einem an die Oberfläche des Substrats angrenzenden Teil des Substrats dem Gehalt an Eta-Phase im innersten Teil des Substrats entspricht.

4. Beschichtetes Schneidwerkzeug nach einem der vorstehenden Ansprüche, wobei die WC-Korngröße in dem Hartmetall 0,6 bis 0,8 $\mu$m beträgt, gemessen als mittlerer linearer Schnitt auf einem LOM-Bild bei 1000- oder 2000-facher Vergrößerung.

5. Beschichtetes Schneidwerkzeug nach einem der vorstehenden Ansprüche, wobei das Hartmetall aus WC-Körnern und Eta-Phase-Körnern in einem metallischen Binder aus Co und Cr besteht und wobei etwas W in dem metallischen Binder gelöst ist.

6. Beschichtetes Schneidwerkzeug nach einem der vorstehenden Ansprüche, wobei die Beschichtung eine PVD-Beschichtung ist.

7. Beschichtetes Schneidwerkzeug nach einem der vorstehenden Ansprüche, wobei die Beschichtungsdicke 2,5 bis 4,5 $\mu$m beträgt, gemessen in einem polierten Querschnitt in einem SEM-Bild.

8. Beschichtetes Schneidwerkzeug gemäß einem der vorstehenden Ansprüche, wobei die Beschichtung eine mehrlagige Beschichtung mit wenigstens einer Schicht aus TiAlN und wenigstens einer Schicht aus $Al_2O_3$ ist.

9. Beschichtetes Schneidwerkzeug nach Anspruch 8, wobei das $\gamma$-$Al_2O_3$ nanokristallines $\gamma$-$Al_2O_3$ ist.

10. Beschichtetes Schneidwerkzeug nach einem der Ansprüche 8-9, wobei das Ti:Al-Verhältnis in TiAlN 33:67 beträgt.

11. Beschichtetes Schneidwerkzeug nach einem der vorstehenden Ansprüche, wobei die Beschichtung eine äußerste Schicht aus metallischem Al als Verschleißanzeigeschicht aufweist, vorzugsweise mit einer Schichtdicke von 30 bis 100 nm.

12. Beschichtetes Schneidwerkzeug nach einem der vorstehenden Ansprüche, wobei die Beschichtung aus den Unterschichten TiAlN/$\gamma$-$Al_2O_3$/TiAlN/$\gamma$-$Al_2O_3$/TiAlN/$\gamma$-$Al_2O_3$/TiAlN/Al besteht.

13. Beschichtetes Schneidwerkzeug nach einem der vorstehenden Ansprüche, wobei das Schneidwerkzeug ein Fräseinsatz ist.

14. Beschichtetes Schneidwerkzeug nach einem der vorstehenden Ansprüche, wobei das Schneidwerkzeug strahlgehärtet wurde.

**Revendications**

1. Outil de coupe revêtu comprenant un corps de carbure cémenté et un revêtement sur celui-ci, où le carbure cémenté comprend de 75 à 91 % en volume de grains de WC et des grains de phase êta et un liant métallique, où le liant métallique comprend du Co et du Cr, la teneur en Co dans le carbure cémenté va de 6 à 12 % en poids, de préférence de 6 à 10 % en poids, de façon davantage préférée de 7 à 8 % en poids, la teneur en phase êta va de 4 à 5 % en volume et la taille de grains moyenne des grains de phase êta va de 1 à 5 $\mu$m, de préférence de 2 à 4 $\mu$m, de façon davantage préférée de 2 à 3 $\mu$m, le pourcentage en volume et la taille de grains moyenne des grains êta sont mesurés selon la méthode décrite dans la description, où la teneur en carbone substochiométrique est comprise entre -0,30 et -0.16 % en poids, **caractérisé en ce que** la rapport Cr/Co dans le carbure cémenté va de 1,0 à 2,5 %.

2. Outil de coupe revêtu selon la revendication 1, dans lequel le rapport Cr/Co dans le carbure cémenté va de 1,5 à 2,5 %.

3. Outil de coupe revêtu selon l'une quelconque des revendications précédentes, dans lequel la teneur de phase êta dans une partie du substrat adjacente à la surface du substrat correspond à la teneur de phase êta dans la partie la plus intérieure du substrat.

4. Outil de coupe revêtu selon l'une quelconque des revendications précédentes, dans lequel la taille de grains de WC dans le carbure cémenté va de 0,6 à 0,8 $\mu$m telle que mesurée par interception linéaire moyenne sur une image de microscopie optique (MO) à un grossissement de 1 000 x ou 2 000 x.

5. Outil de coupe revêtu selon l'une quelconque des revendications précédentes, dans lequel le carbure cémenté se compose de grains de WC et de grains de phase êta dans un liant métallique de Co et de Cr et où une certaine quantité de W est dissoute dans le liant métallique.

6. Outil de coupe revêtu selon l'une quelconque des revendications précédentes, dans lequel le revêtement est un revêtement appliqué par dépôt en phase vapeur (PVD).

7. Outil de coupe revêtu selon l'une quelconque des revendications précédentes, dans lequel l'épaisseur de revêtement va de 2,5 à 4,5 $\mu$m telle que mesurée dans une coupe transversale polie dans une image de microscopie électronique à balayage (MEB).

8. Outil de coupe revêtu selon l'une quelconque des revendications précédentes, dans lequel le revêtement est une multicouche ayant au moins une couche de TiAlN et au moins une couche d'$Al_2O_3$.

9. Outil de coupe revêtu selon la revendication 8, dans lequel l'$Al_2O_3$ est de la $\gamma$-$Al_2O_3$ nanocristalline.

10. Outil de coupe revêtu selon l'une quelconque des revendications 8 et 9, dans lequel le rapport Ti:Al dans le TiAlN est de 33:67.

11. Outil de coupe revêtu selon l'une quelconque des revendications précédentes, dans lequel le revêtement comprend une couche la plus extérieure d'Al métallique en tant que couche d'indication d'usure, de préférence ayant une épaisseur de couche de 30 à 100 nm.

12. Outil de coupe revêtu selon l'une quelconque des revendications précédentes, dans lequel le revêtement se compose des sous-couches TiAlN/$\gamma$-$Al_2O_3$/TiAlN/$\gamma$-$Al_2O_3$/TiAlN/$\gamma$-$Al_2O_3$/ TiAlN/Al.

13. Outil de coupe revêtu selon l'une quelconque des revendications précédentes, où l'outil de coupe est une plaquette de fraisage.

14. Outil de coupe revêtu selon l'une quelconque des revendications précédentes, où l'outil de coupe a été soumis à un grenaillage.

Fig. 1

Fig. 2

Fig. 3

Fig. 4

20 µm

Fig. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017108610 A
- EP 3393703 B1
- EP 3839097 A1
- US 4843039 A